# DEMANDE DE BREVET EUROPEEN

(11) **EP 0 542 592 A1**
(43) Date de publication de la demande: **19.05.1993**
(21) Numéro de dépôt: 92402904.4
(22) Date de dépôt: 26.10.1992
(51) Int. Cl.: G06F 11/22, G06F 11/20

(54) **Mémoire en circuit intégré comportant un système de redondance**

(30) Priorité: 13.11.1991 FR 9113947
(71) Demandeur: SGS-THOMSON MICROELECTRONICS S.A., F-94250 Gentilly (FR)
(72) Inventeur: Silvestre de Ferron, Gérard, F-75116 Paris (FR)
(74) Mandataire: Schmit, Christian Norbert Marie

(57) **Abrégé**

L'invention concerne la redondance dans les mémoires en circuit intégré. Une colonne de redondance CR1 est mise en service à la place d'une colonne défectueuse à l'aide d'un circuit de redondance comportant:
- une batterie de fusibles (F1 à F4) représentant l'adresse mémorisée d'une colonne défectueuse,
- un fusible de validation (FV) autorisant lorsqu'il est programmé la mise en service effective de la redondance,
- et un fusible de dévalidation (FD) interdisant lorsqu'il est programmé cette mise en service et ayant priorité sur le fusible de validation.

On peut ainsi invalider définitivement une batterie de fusible qui n'aurait pas donné les résultats attendus après une opération de réparation.

Les fusibles sont des cellules de mémoire UPROM.

## Description

L'invention concerne les mémoires réalisées en circuits intégrés, et plus particulièrement celles qui comportent des circuits de redondance.

Une mémoire intégrée comporte de nombreuses cellules de mémoire en lignes et en colonnes sur une très petite surface et un défaut technologique sur une seule cellule entraîne la mise au rebut de la totalité de la mémoire. Pour éviter cela on utilise des circuits de redondance qui sont mis en service si un défaut est constaté au moment du test de la mémoire.

Le plus souvent, la mémoire comportera plusieurs lignes ou plusieurs colonnes de remplacement (ou à la fois plusieurs lignes et plusieurs colonnes). Chaque ligne ou colonne de remplacement peut être substituée à une ligne ou une colonne défectueuse de la mémoire.

Mais le remplacement doit être transparent pour l'utilisateur, c'est-à-dire que celui-ci doit pouvoir appliquer à l'entrée de la mémoire l'adresse de la ligne ou colonne défectueuse pour lire ou écrire à cette adresse exactement comme si elle n'était pas défectueuse. L'adresse des lignes ou colonnes défectueuses est donc enregistrée à l'intérieur du circuit intégré; lorsque l'utilisateur présente à l'entrée de la mémoire une adresse de ligne ou colonne défectueuse, ce sont les circuits internes de la mémoire qui reconnaissent qu'il s'agit d'une des adresses défectueuses enregistrées, et qui aiguillent les signaux électriques vers les colonnes de remplacement. L'utilisateur n'intervient en rien dans ce processus.

Pour enregistrer les adresses défectueuses, on a utilisé et on utilise toujours ce qu'on appelle au sens large des "fusibles" : un fusible définit une information binaire selon son état (vierge ou programmé); pour chaque adresse défectueuse à enregistrer, on utilise une batterie de plusieurs fusibles, en nombre égal au nombre de bits servant à définir une adresse. Pour une adresse de p bits, il y a une batterie de p fusibles. L'état intact ou programmé des différents fusibles d'une batterie définit une adresse de p bits. S'il y a N lignes ou colonnes de redondance, c'est-à-dire si on veut pouvoir remplacer N lignes ou colonnes défectueuses par des lignes ou colonnes de remplacement, il faut N batteries.

Les éléments de remplacement (lignes ou colonnes de remplacement) peuvent eux-mêmes être testés avant d'être utilisés (brevet FR-A-2611400).

Lorsqu'on a besoin d'un élément de remplacement pour remplacer un élément défectueux, on stocke l'adresse de cet élément défectueux dans une batterie de fusibles et on grille un fusible de validation associé à cette batterie pour indiquer qu'elle est effectivement utilisée pour définir une opération de remplacement.

On atteint ainsi un bon rendement de fabrication.

A l'origine, les fusibles étaient des fusibles réels ayant un état intact et un état détruit irréversiblement : par exemple un fusible intact est un court-circuit et un fusible détruit est un circuit ouvert, ou le contraire. La destruction est irréversible et est opérée par une impulsion électrique forte dirigée vers le fusible à détruire; la destruction pouvait être aussi effectuée par un rayon laser dirigé vers ce fusible.

Toutefois, aujourd'hui, on tend de plus en plus à utiliser comme "fusibles" des mémoires électriques non volatiles ayant un premier état "vierge" et un deuxième état "programmé", le passage de l'état vierge à l'état programmé étant irréversible. L'avantage est que ces "fusibles" logiques, sous forme de mémoires, sont plus faciles à programmer.

Il est nécessaire de rendre ces fusibles totalement irréversibles; en effet, on n'effectue qu'une fois, au moment de la fabrication, le test et la correction par des éléments de redondance, et l'association entre un élément redondant et l'adresse stockée dans une batterie de fusibles doit être permanente. Si la mémoire était effacée par exemple par des rayons ultraviolets, on détruirait la réparation effectuée au moment du test de la mémoire.

C'est pourquoi on utilise comme fusibles des éléments de mémoire non volatiles d'un type particulier, appelés UPROM (de l'anglais "unerasable read-only memory"), qui sont des mémoires non volatiles électriquement programmables et non effaçables.

Technologiquement, ces mémoires sont réalisées comme des EPROM, c'est-à-dire comme des mémoires non volatiles programmables électriquement et effaçables par ultra-violets, c'est-à-dire avec des transistors à grille flottante, mais elles sont recouvertes d'un large dépôt métallique (en principe de l'aluminium), qui les protège de tout rayonnement susceptible de les effacer une fois programmées.

L'état vierge ou intact d'un tel élément de mémoire est celui dans lequel il n'y a pas de charges électriques piégées dans la grille flottante; la cellule peut laisser passer un courant lorsqu'on applique des tensions de lecture appropriées. L'état "grillé" ou programmé est celui dans lequel des charges sont piégées dans la grille flottante et empêchent la cellule de laisser passer un courant lorsqu'on applique les tensions de lecture.

On s'est aperçu que dans les opérations technologiques de fabrication de la mémoire, il y avait un risque que le métal recouvrant les cellules UPROM se charge électriquement. Cela peut se passer pendant le dépôt de ce métal, ou pendant sa gravure ou pendant toute autre opération ultérieure. Or cette charge du métal induit, par effet capacitif, un effet analogue à celui d'une charge de la grille flottante : elle empêche le passage de courant de lecture lorsqu'on lit l'état de la cellule. Il en résulte qu'une cellule vierge risque d'être lue comme une cellule programmée. Et on ne sait pas effacer cette charge parasite.

Lorsqu'une cellule UPROM sert à définir un bit d'une adresse défectueuse, on comprend donc qu'on peut aboutir au stockage d'une adresse erronée.

L'adresse d'une colonne défectueuse n'est pas reconnue lorsqu'elle se présente et la colonne défectueuse n'est donc pas remplacée par une colonne de redondance. Et inversement, c'est une autre adresse, adresse de colonne non défectueuse, qui est détectée et qui entraîne la mise en service (inutile) d'une colonne de redondance.

L'invention vise à éviter cette situation, et également à éviter des situations analogues qui pourraient se présenter dans des cas similaires, même si la cause n'en était pas précisément dans la technologie de fabrication des mémoires non volatiles qui servent maintenant de fusibles de mémorisation d'adresses. L'invention apporte cependant son effet même si les fusibles sont de type différents, c'est à dire par exemple s'ils sont des fusibles classiques, en polysilicium ou même en aluminium ou autres.

Selon l'invention, on propose une mémoire intégrée comportant un réseau de cellules de mémoire et des éléments de redondance, plusieurs batteries de fusibles pour stocker chacune une adresse d'élément défectueux du réseau à remplacer par un élément de redondance, un fusible de validation associé à chaque batterie et indiquant lorsqu'il est programmé que la batterie associée est mise en service, le fusible de validation étant connecté de manière à assurer, uniquement s'il est programmé, une mise en service d'un élément de redondance et une invalidation de l'élément défectueux, ceci chaque fois que l'adresse appliquée à la mémoire est identique à l'adresse stockée dans la batterie associée à ce fusible de validation, la mémoire étant caractérisé en ce qu'elle comporte, associé à chaque batterie de fusibles, un fusible supplémentaire de dévalidation annulant lorsqu'il est programmé l'effet du fusible de validation programmé.

Par conséquent, lors du test de la mémoire, si on trouve un élément défectueux on met en service un élément de réparation et on teste à nouveau la mémoire; si le résultat est toujours mauvais pour la même adresse, on programme le fusible de dévalidation, invalidant ainsi la première opération de réparation, et on met en service une autre batterie de fusible et un autre élément de réparation. Le fusible de dévalidation est prioritaire (lorsqu'il est programmé) sur le fusible de validation programmé.

On aurait pu imaginer de laisser en service la première réparation (puisqu'elle se contente de remplacer inutilement une colonne correcte par une colonne de réparation également correcte). Mais selon l'invention on propose d'aller plus loin et de supprimer cette réparation inutile; en effet cette réparation résulte a priori d'une erreur d'adresse stockée dans la batterie de fusible, cette erreur venant sans doute d'une charge erronée de la grille flottante d'un transistor. Ce type d'erreur peut évoluer dans le temps, les charges se modifiant progressivement. Il y aurait une évolution incontrôlable des structures de redondance, y compris à un moment ou un test et une réparation ne sont plus possibles (lorsque la mémoire fonctionne dans une application). Le test ayant donc montré une certaine absence de fiabilité d'une batterie de fusibles, on invalide totalement cette batterie par action sur le fusible de dévalidation. Cette opération n'est pas réversible.

Le fusible de dévalidation est de préférence, comme les fusibles de la batterie et comme le fusible de validation, une mémoire non volatile programmable électriquement et non effaçable.

D'autres caractéristiques et avantages de l'invention apparaîtront à la lecture de la description détaillée qui suit et qui est faite en référence aux dessins annexés dans lesquels :
- la figure 1 représente un schéma synoptique général d'une mémoire comportant des éléments de redondance;
- la figure 2 représente un schéma synoptique d'un circuit de redondance comportant l'amélioration apportée par l'invention;
- la figure 3 représente un exemple de réalisation détaillé.

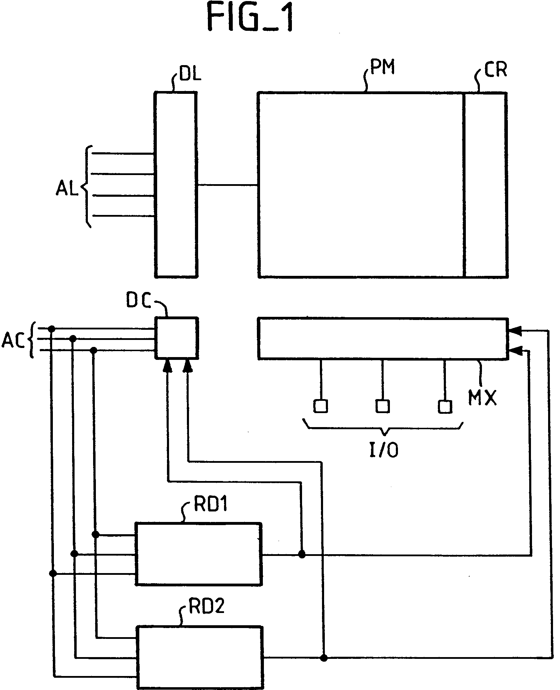

A la figure 1 on a rappelé le schéma général d'une mémoire incorporant des éléments de redondance.

La mémoire comporte un plan mémoire PM agencé en réseau de lignes et colonnes de cellules mémoires individuelles adressables au moyen d'un décodeur de ligne DL et d'un décodeur de colonne DC. Le décodeur de ligne sert à désigner une ligne déterminée lorsqu'il reçoit une adresse de ligne AL. Le décodeur de colonne reçoit une adresse de colonne et commande en conséquence un multiplexeur MX pour désigner un mot déterminé de la ligne sélectionnée. Le multiplexeur sélectionne alors des colonnes correspondant à ce mot et permet de connecter ces colonnes à des plots d'entrée-sortie I/O. Ces plots servent à transmettre, en lecture ou en écriture, un mot de données enregistrées dans la mémoire. Cette organisation, bien qu'elle ne soit pas la seule possible, est la plus généralement utilisée et sera prise comme base d'illustration de la présente invention.

Le circuit intégré comporte par ailleurs une circuiterie de redondance.

Pour simplifier on considère que les seuls éléments de redondance sont des colonnes de réparation destinées à remplacer des colonnes défectueuses. Mais il pourrait aussi y avoir des lignes de réparation pour remplacer des lignes défectueuses.

Dans l'exemple représenté à titre indicatif il y a deux colonnes de réparation placées dans une zone CR à côté des colonnes du plan mémoire PM. Mais il pourrait y en avoir plus de deux. Dans la suite on considèrera que le mot "colonne" correspond à une colonne physique de cellules de la mémoire, mais par extension l'invention est applicable aussi si le mot "colonne" désigne un groupe de colonnes remplaçant simultanément tout un groupe défectueux de colonnes de cellules.

Lorsque une colonne de réparation est mise en service à la suite d'un test, par suite de la détection d'une colonne défectueuse, la colonne de réparation doit être aiguillée par le multiplexeur vers l'un des plots d'entrée/sortie I/O à la place de la colonne défectueuse.

Pour cela on prévoit pour chaque colonne de réparation un circuit de redondance respectif désigné sur la figure 1 par RD1 pour la première colonne, RD2 pour la deuxième. Ce circuit possède les fonctions suivantes :
- il possède en mémoire l'adresse de la colonne défectueuse;
- il reçoit les adresses de colonne AC appliquées à l'entrée de la mémoire;
- il reste inactif si l'adresse ne correspond pas à l'adresse enregistrée;
- il aiguille la colonne de réparation vers les plots d'entrée-sortie à la place de la colonne défectueuse lorsqu'il reçoit l'adresse correspondant à la colonne défectueuse.

Cette opération d'aiguillage est effectuée à l'intérieur du multiplexeur MX qui est donc contrôlé par les circuits de redondance RD1 et RD2. Pour déconnecter la colonne défectueuse, les circuits de redondance peuvent par exemple désactiver le décodeur de colonne.

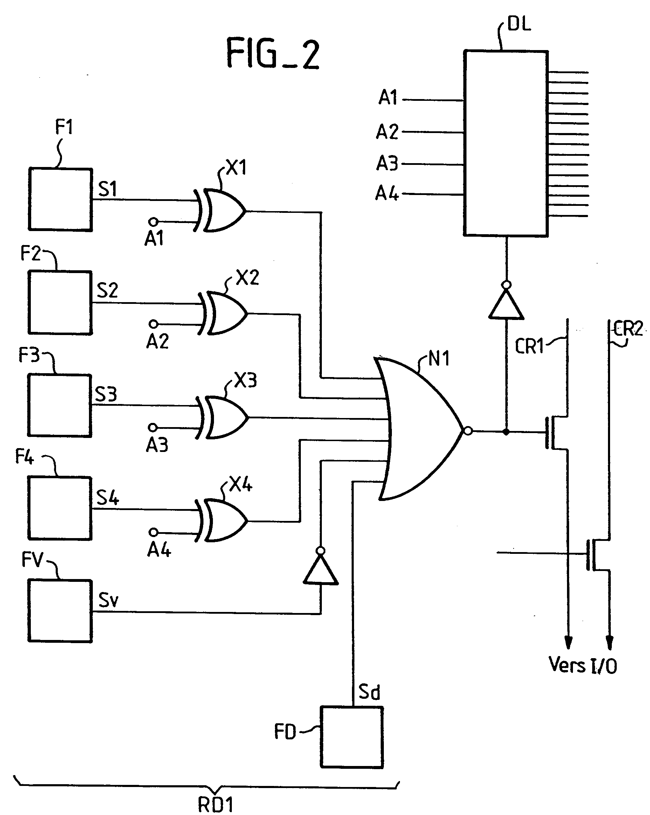

La figure 2 représente un schéma d'un circuit de redondance selon l'invention tel que RD1, affecté à une colonne de redondance déterminée CR1.

Ce circuit comporte d'abord classiquement une batterie de fusibles mémorisant une adresse de colonne déterminée. On a représenté sur la figure des blocs F1, F2, F3, F4 représentant quatre fusibles; cette batterie de quatre fusibles permet d'enregistrer une adresse de quatre bits si on suppose à titre d'exemple qu'il y a quatre bits d'adresse de colonne pour désigner un mot de la mémoire. L'état vierge du fusible définit par exemple un bit d'adresse égal à zéro et l'état programmé un bit d'adresse égal à 1.

Chaque bloc F1 à F4 représente symboliquement à la fois un fusible et les éléments de circuit qui permettent de convertir l'état du fusible en un niveau de tension logique exploitable. C'est pourquoi on a représenté chaque bloc F1 à F4 avec une sortie de signal électrique respective S1 à S4. Pour ne pas alourdir la figure on n'a pas représenté la circuiterie de programmation des fusibles. Cette circuiterie est cependant nécessaire si les fusibles sont programmés électriquement.

De préférence le fusible proprement dit est constitué par une cellule de mémoire UPROM, dont le coeur est un transistor à grille flottante. La lecture se fait par application d'une tension de lecture à la grille flottante et par analyse du courant qui traverse alors la cellule (courant détectable pour une cellule vierge, pas de courant pour une cellule programmée).

Le circuit de redondance doit commander le remplacement d'une colonne défectueuse'par une colonne redondante seulement lorsque l'adresse appliquée par l'utilisateur de la mémoire à l'entrée de celle-ci est justement l'adresse de la colonne défectueuses adresse qui est définie par la combinaison des états des fusibles F1 à F4. C'est pourquoi on prévoit quatre portes OU-Exclusif X1 à X4; chacune possède une première entrée recevant un bit respectif (A1 à A4) de l'adresse de colonne appliquée à l'entrée de la mémoire et une deuxième entrée recevant la sortie S1 à S4 d'un fusible respectif. Si le bit d'adresse appliqué est identique au bit défini par l'état du fusible correspondant, la porte OU-exclusif fournit un bit 0; si au contraire le bit d'adresse est différent du bit stocké, la porte OU-exclusif fournit un bit 1. Ce n'est que lorsqu'il y a coïncidence bit à bit de l'adresse appliquée et de l'adresse stockée que toutes les portes OU-Exclusif X1 à X4 fournissent simultanément un zéro. Sinon, au moins un bit 1 est présent.

Une porte NOR N1 recevant toutes les sorties des portes X1 à X4 permet de détecter la coïncidence : sa sortie ne passe à 1 que si toutes les portes OU-Exclusif fournissent un 0.

De plus, on prévoit un fusible supplémentaire de validation de la circuiterie de redondance RD1 associée à la colonne CR1. En effet, s'il n'y aucune colonne défectueuse à remplacer par la colonne CR1, on ne grille aucun des fusibles F1 à F4; il ne faut pas que l'existence de quatre fusibles intacts soit interprétée comme l'existence d'une adresse défectueuse 0000; la programmation du fusible de validation FV sert donc à confirmer qu'il y a une colonne défectueuse à remplacer.

Pour cela, on connecte la sortie Sv de ce fusible, par l'intermédiaire d'un inverseur, à une entrée supplémentaire de la porte NOR N1. La redondance n'est mise en service que si à la fois le fusible de validation FV est programmé (état 1) et s'il y a coïncidence exacte entre l'adresse de mémoire et l'adresse enregistrée dans la batterie de fusibles.

La sortie de la porte NOR N1 commande
- d'une part la mise en service de la colonne de redondance CR1; ceci est figuré symboliquement par un transistor T1 permettant de relier la colonne à un des plots d'entrée-sortie I/O; ce transistor fait partie du multiplexeur MX de la figure 1;
- d'autre part la déconnexion de la colonne défectueuse (non représentée); ceci est représenté symboliquement par une connexion issue de la porte NOR N1 et allant désactiver le décodeur de colonne DL; le décodeur commande le multiplexeur MX (figure 1) qui ne pourra plus connecter la colonne défectueuse; la réalisation pratique dépend de la construction de la mémoire.

Selon l'invention, on prévoit en outre un fusible de dévalidation FD. Il est connecté à une autre entrée de la porte NOR N1. Toutefois la connexion entre le fusible de dévalidation et la porte NOR est telle que le sens d'action est l'inverse de celui du fusible de validation : le fusible de dévalidation fournit à la porte NOR un niveau 0 lorsqu'il est vierge et 1 lorsqu'il est programmé.

Le fusible de dévalidation est normalement vierge lorsqu'on met en service la redondance. Il n'influe donc pas sur l'état de sortie de la porte NOR : celle-ci passe à 1 lorsque à la fois le fusible de validation est programmé et l'adresse de colonne appliquée est justement l'adresse défectueuse enregistrée dans la batterie. L'état vierge du fusible de dévalidation ne modifie pas cette condition.

Mais si on s'aperçoit au cours du test que la colonne est toujours défectueuse même après mise en service de la redondance, on programme le fusible de dévalidation. Sa sortie Sd passe alors à 1, empêchant ainsi que la sortie de la porte NOR passe à 1. Il n'est plus possible de remplacer la colonne défectueuse par la colonne de redondance. La batterie de fusible et la colonne de redondance associée sont définitivement neutralisées. Etant donné le choix de portes logiques fait ici, on voit que le fusible de dévalidation a priorité, lorsqu'il est programmé, sur le fusible de validation programmé, c'est-à-dire qu'en présence d'ordres contradictoires (mise en service ordonnée par le fusible de validation, interdiction ordonnée par le fusible de dévalidation), c'est la programmation du fusible de dévalidation qui détermine le fonctionnement. Inversement, lorsque le fusible de validation est vierge, il a priorité sur l'état du fusible de dévalidation pour interdire la redondance. Toutefois le cas où le fusible de validation est vierge et le fusible de dévalidation est programmé ne devrait pas apparaître en pratique. Au cas où elle appraîtrait, il serait alors simplement impossible d'activer cet élément, ce qui est le but logique de ce fusible. Si la circuiterie utilisée était différente de celle décrite ici (puisqu'il est possible de réaliser les mêmes fonctions avec d'autres circuits), il faudrait évidemment tenir compte de cette condition de priorité.

Le fusible de dévalidation est aussi de préférence réalisé à l'aide d'une cellule de mémoire UPROM.

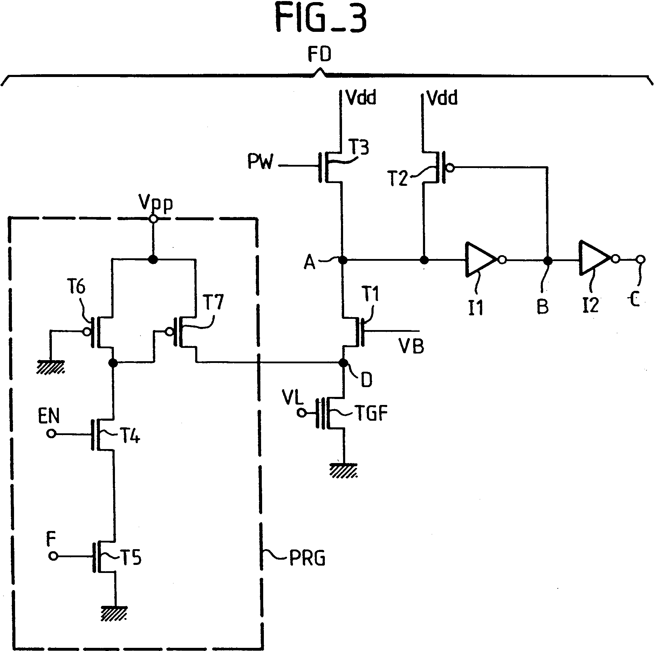

A titre d'exemple de réalisation pratique on a représenté à la figure 3 le détail d'un bloc tel que le bloc FD comportant le fusible de dévalidation et la circuiterie associée qui permet de convertir son état vierge ou programmé en un niveau de tension logique 0 ou 1.

Cette circuiterie est d'ailleurs la même que celle que celle qui est associée à chacun des fusibles F1 à F4 et au fusible de validation.

Le fusible est une cellule UPROM comportant un transistor à grille flottante TGF dont la source est à la masse, le drain est relié par l'intermédiaire d'un transistor T1 à un noeud de circuit A. Le noeud A est relié par un premier inverseur I1 à un noeud B. Et le noeud B est relié par un deuxième inverseur I2 à un noeud C sur lequel apparaît le signal Sd définissant l'état du fusible. Le noeud A à l'entrée de l'inverseur Il est relié à une source de tension d'alimentation Vdd par l'intermédiaire d'un transistor T2 à canal P, dont la grille est reliée au noeud B. Un transistor T3, commandé par un signal PW relie le noeud A à la tension Vdd. Une circuiterie PRG de programmation du fusible est connectée au drain (noeud D) du transistor à grille flottante TGF.

Le transistor T1 a sa grille polarisée, en mode d'utilisation, par une tension VB qui le rend conducteur. Il peut par ailleurs être bloqué pendant la phase de programmation du fusible.

Le transistor T2 constitue avec l'inverseur I1 un circuit convertisseur courant/tension permettant de convertir le courant du transistor TGF en une tension logique (niveau O si le transistor TGF est vierge, niveau 1 s'il est programmé).

Le transistor T3 est rendu conducteur par le signal PW ("power-on reset") qui apparaît à la remise sous tension du circuit et qui facilite le positionnement au niveau logique 1 du noeud A lorsque le transistor TGF est programmé.

Enfin, la circuiterie de programmation PRG comporte des moyens pour appliquer au transistor TGF la tension Vpp relativement élevée nécessaire à sa programmation. Cette circuiterie est par exemple déclenchée par un signal EN appliqué à la grille d'un transistor T4. Et elle est validée ou non (selon que le fusible doit rester vierge ou être programmé) par un signal logique F appliqué à la grille d'un transistor T5. Sur la figure, le transistor T6 joue le rôle de résistance pour limiter le courant dans la branche T4, T5, T6.

Enfin, la tension appliquée à la grille de commande du transistor à grille flottante est, en mode d'utilisation, une tension VL apte à le rendre conducteur s'il est vierge et inapte à le rendre conducteur s'il est programmé. En mode de programmation, la tension appliquée à la grille de commande de TGF est celle qui convient pour charger la grille flottante; elle dépend du type de transistor utilisé.

Le signal F appliqué pour la programmation du fusible de dévalidation est un ordre logique donné au moment du test et mis à 1 uniquement si la réparation par la batterie de fusible et la colonne de redondance associée n'a pas donné satisfaction.

Pour les circuits associés aux fusibles F1 à F4 de la batterie, le signal F est tout simplement un bit d'adresse de la colonne défectueuse. Pour le fusible de validation FV, le signal F est l'ordre de validation donné pour assurer la mise en service de la redondance.

Le signal Sd apparaissant à la sortie du circuit est égal au niveau logique 0 si le transistor à grille flottante est vierge (naturellement conducteur); il est égal à 1 si le transistor TGF est programmé.

## Revendications

1. Mémoire intégrée comportant un réseau de cellules de mémoire (PM) et des éléments de redondance (CR), plusieurs batteries de fusibles (RD1, RD2) pour stocker chacune une adresse d'élément défectueux du réseau à remplacer par un élément de redondance, un fusible de validation (FV) associé à chaque batterie et indiquant lorsqu'il est programmé que la batterie associée est mise en service, le fusible de validation étant connecté de manière à assurer, uniquement s'il est programmé, une mise en service d'un élément de redondance et une invalidation de l'élément défectueux chaque fois que l'adresse appliquée à la mémoire est identique à l'adresse stockée dans la batterie associée à ce fusible de validation, mémoire caractérisée en ce qu'elle comporte, associé à chaque batterie de fusibles, un fusible supplémentaire de dévalidation (FD) annulant lorsqu'il est programmé l'effet du fusible de validation programmé.

2. Mémoire selon la revendication 1, caractérisé en ce que les fusibles (F1 à F4, FD, FV) sont des cellules de mémoire électriquement programmables et non effaçables.

3. Mémoire selon l'une des revendications 1 et 2, caractérisée en ce que les fusibles de la batterie sont connectés chacun à une porte OU-Exclusif respective recevant par ailleurs un bit respectif d'adresse de la mémoire, les sorties des portes OU-exclusif sont reliées aux entrées d'une porte NOR, le fusible de validation est relié à une entrée supplémentaire de la porte NOR, et le fusible de dévalidation est relié à encore une autre entrée de la porte NOR, le signal issu du fusible de dévalidation étant cependant inversé par rapport au signal issu du fusible de validation afin que l'effet du fusible de dévalidation soit inverse de celui du fusible de validation.
